# EUROPÄISCHE PATENTSCHRIFT

(11) **EP 1 128 428 B1**
(45) Veröffentlichungstag und Bekanntmachung des Hinweises auf die Patenterteilung: **31.10.2007**
(21) Anmeldenummer: 01104254.6
(22) Anmeldetag: 22.02.2001
(51) Int. Cl.: H01L 21/02, H01L 21/3105, H01L 21/8246

(54) **Verfahren zur Herstellung eines Halbleiterbauelements**
Method of manufacturing a semiconductor device
Procédé de fabrication d'un dispositif semi-conducteur

(30) Priorität: 25.02.2000 DE 10010284
(43) Veröffentlichungstag der Anmeldung: 29.08.2001
(73) Patentinhaber: Qimonda AG, 81739 München (DE)
(72) Erfinder: Hoepfner, Joachim, 82152 Planegg (DE)
(74) Vertreter: Graf Lambsdorff, Matthias

(56) Entgegenhaltungen:
- EP-A- 0 862 203
- EP-A- 0 915 522
- YONG TAK LEE ET AL: "EFFECTS OF ENCAPSULATING BARRIER LAYER ON FERROELECTRIC PROPERTIES OF IR/IRO2/PZT/PT/IRO2 CAPACITOR" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, 1999, Seiten 394-395, XP000935138
- PATENT ABSTRACTS OF JAPAN Bd. 1998, Nr. 14, 31. Dezember 1998 (1998-12-31) & JP 10 233489 A (SAMSUNG ELECTRON CO LTD), 2. September 1998 (1998-09-02)

## Beschreibung

Die Erfindung betrifft ein Verfahren zur Herstellung eines Halbleiterbauelements nach dem Oberbegriff der Patentansprüche 1 und 2.

Konventionelle mikroelektronische Halbleiterspeicher-Bauelemente (DRAMs) bestehen im wesentlichen aus einem Schalttransistor und einem Speicherkondensator. Die gespeicherte Information wird dabei durch den Ladungszustand des Speicherkondensators repräsentiert. Aufgrund von Entladungsvorgängen muß der Ladungszustand einer (flüchtigen) DRAM-Speicherzelle ständig erneuert werden.

Als Kondensator-Dielektrika werden in DRAMs üblicherweise Oxid- oder Nitridschichten verwendet, die eine Dielektrizitätskonstante von maximal etwa 8 aufweisen. Zur Verkleinerung des Speicherkondensators sowie zur Herstellung von nichtflüchtigen Speichern werden "neuartige", metalloxidhaltige Kondensatormaterialien (Paraelektrika oder Ferroelektrika) mit deutlich höheren Dielektrizitätskonstanten benötigt. Bekannte Beispiele für ferroelektrische Kondensatormaterialien sind SrBi₂(Ta,Nb)₂O₉ (SBT oder SBTN), Pb(Zr,Ti)O₃ (PZT), Bi₄Ti₃O₁₂ (BTO), ein bekanntes Beispiel für ein paraelektrisches Hoch-Epsylon-Kondensatormaterial ist (Ba,Sr)TiO₃ (BST).

Die Verwendung dieser neuartigen Kondensatormaterialien bereitet technologische Schwierigkeiten. Zunächst lassen sich diese neuartiger Materialien nicht mehr mit dem traditionellen Elektrodenmaterial polykristallines Silizium kombinieren. Deshalb müssen inerte Elektrodenmaterialien, wie beispielsweise Platin (Pt) oder leitfähige Metalloxide (z.B. RuO₂), eingesetzt werden. Der Grund hierfür ist, daß die neuartigen Kondensatormaterialien nach dem Abscheiden in einer Sauerstoff-haltigen Atmosphäre bei Temperaturen von etwa 550-800°C gegebenenfalls mehrfach getempert ("konditioniert") werden müssen, und nur die genannten inerten Elektrodenmaterialien eine ausreichende Temperaturstabilität aufweisen, um eine unerwünschte chemische Reaktion zwischen Elektrodenmaterial und Kondensatormaterial zu vermeiden.

Eine weitere Schwierigkeit bei der Herstellung derartiger Speicherkondensatoren beruht darauf, daß metalloxidhaltige Kondensatormaterialien in der Regel eine hohe Empfindlichkeit gegenüber Wasserstoff aufweisen. Nach der Bildung des Speicherkondensators sind jedoch Prozeßschritte durchzuführen, die in Wasserstoff-haltiger Umgebung stattfinden. Nachteilig ist dabei, daß die Pt-Elektroden gegenüber Wasserstoff durchlässig sind und daher keinen wirksamen Schutz vor einer Wasserstoff-Schädigung des Kondensatormaterials bilden.

Grundsätzlich bieten sich verschiedene Lösungsmöglichkeiten für das letztgenannte Problem an. Aus materialtechnologischer Sicht kann versucht werden, ein Elektrodenmaterial zu finden, das nicht durchlässig für Wasserstoff ist, oder ein Dielektrikummaterial zu finden, das nicht gegenüber Wasserstoff empfindlich ist. Verfahrenstechnologisch kann versucht werden, nach der Bildung des Speicherkondensators jegliche Prozeßschritte zu vermeiden, die in Wasserstoff-haltiger Umgebung ablaufen. Bei sämtlichen dieser Lösungsvarianten ergeben sich in der Praxis jedoch weitere gravierende Schwierigkeiten.

Im Stand der Technik wurde bereits versucht, das Problem durch Abscheiden einer Wasserstoff-Barriereschicht auf dem Speicherkondensator zu lösen. In der U.S.-Patentschrift 5,523,595 wird ein Herstellungsverfahren für ein Halbleiterbauelement mit einem ferroelektrischen Speicherkondensator beschrieben. Nach dem Aufbau des Speicherkondensators wird über diesem mittels eines CVD-Prozesses eine Wasserstoff-Barriereschicht bestehend aus TiON erzeugt. Durch die Barriereschicht wird das Eindringen von Wasserstoff durch die obere Pt-Elektrode des Speicherkondensators verhindert. Nachteilig ist jedoch, daß ein Eindringen von Wasserstoff durch die untere Pt-Elektrode sowie ein seitliches Eindringen von Wasserstoff in das Ferroelektrikum weiterhin möglich sind. Ein vollständiger Schutz des Kondensator-Ferroelektrikums gegenüber einer Degradation durch Wasserstoff ist daher nicht gegeben.

Das Dokument EP 915522 offenbart ein Verfahren zum Einkapseln eines Ferroelektrischen Kondensators in einer Wasserstoff-Diffusionsbarriere.

Der Erfindung liegt die Aufgabe zugrunde, ein Verfahren zur Herstellung eines Halbleiterbauelements anzugeben, bei welchem ein Speicherkondensator, der ein ferroelektrisches oder paraelektrisches Kondensatormaterial verwendet, ausreichend gegen das Eindringen von Wasserstoff geschützt wird.

Die der Erfindung zugrundeliegende Aufgabenstellung wird durch die Merkmale der unabhängigen Ansprüche gelöst.

Ein wesentlicher Gesichtspunkt der Erfindung besteht darin, daß zum Schutz gegen ein Eindringen von Wasserstoff in das Kondensatormaterial eine Oxidschicht mit einem Barrierestoff dotiert wird. Durch die in die Oxidschicht eingebrachten Barrierestoff-Atome wird die dotierte Oxidschicht weitestgehend undurchlässig gegenüber Wasserstoff.

Mit dem Begriff "Dotierung" ist hier also nicht das Einbringen von Fremdatomen zur Veränderung der Leitfähigkeit (sog. p- oder n-Dotierung) sondern das Einbringen von Fremdatomen zur Verringerung der Diffusionsfähigkeit von Wasserstoff (in einer Oxidschicht) gemeint.

Nach einem ersten Aspekt der Erfindung (Anspruch 1) wird eine (erste) dotierte Oxidschicht unterhalb des Kondensators gebildet. Eine andere Möglichkeit (Anspruch 2) besteht darin, über dem Kondensator eine dünne (zweite) Oxidschicht abzuscheiden und diese - zumindest abschnittsweise - zu dotieren.

Diese beiden Aspekte der Erfindung können miteinander kombiniert werden. In diesem Fall kennzeichnet sich eine Verfahrensvariante dadurch, daß die erste dotierte Oxidschicht und die zweite dotierte Oxidschicht den Kondensator allseitig umschließen.

Vorzugsweise handelt es sich bei dem Barrierestoff um Stickstoff. In diesem Fall wird durch die Dotierung eine Nitridisierung der ersten bzw. zweiten Oxidschicht realisiert. Generell können aber auch andere geeignete Stoffe, z.B. Edelgase, als Barrierestoff eingesetzt werden.

Die Dotierung (bzw. Nitridisierung) der Oxidschichten erfolgt unter Zuhilfenahme einer den Barrierestoff enthaltenden Plasma-Entladung. Die Plasma-Entladung ermöglicht, daß in kurzer Zeit (etwa 60 s) eine ausreichend hohe Barrierestoff-Konzentration in der ersten und/oder zweiten Oxidschicht erzeugt wird, ohne daß dabei eine maximale Substrattemperatur im Bereich von 50-120°C überschritten werden muß. Die Plasma-Dotierung ist daher kompatibel mit herkömmlichen Photolack-Maskierungstechniken. Demzufolge kennzeichnet sich ein vorteilhafter Verfahrensablauf dadurch, daß vor der Plasma-Dotierung auf der ersten und/oder zweiten Oxidschicht eine Maske aufgebracht wird, mittels welcher die Dotierung der Oxidschicht strukturiert wird, und daß nachfolgend ein Oxid-Ätzschritt durchgeführt wird. Dadurch wird erreicht, daß bei dem Oxid-Ätzschritt weiterhin (d.h. wie im herkömmlichen Fall ohne Wasserstoff-Barriere) ausschließlich Oxid-Schichtbereiche geätzt werden müssen. Bei der Verwendung z.B. einer TiON-Barriereschicht müßten hingegen alternative Ätzprozeduren zum bereichsweisen Entfernen dieser Schicht eingesetzt werden (um dies zu vermeiden ist diese Schicht in der eingangs genannten U.S.-Patentschrift oberhalb der oberen Anschlußebene angeordnet, wodurch wiederum ihre Wirksamkeit vermindert wird), und bei Verwendung von Sandwich-Schichten (z.B. Nitrid-Oxid-Mehrfachschichten) würden aufgrund der wechselnden Schichtzusammensetzung Unterätzungen bzw. Überhänge im Bereich der Schichtübergänge auftreten, die bei nachfolgenden Prozeßschritten (z.B. dem Befüllen eines herausgeätzten Kontaktlochs) ausgesprochen störend wirken.

Im Falle der angesprochenen Oxid-Ätzung eines Kontaktlochs mittels einer zuvor aufgebrachten (Lack-)Maske kennzeichnet sich eine vorteilhafte Verfahrensvariante dadurch, daß die geschaffene Struktur ein weiteres Mal der Plasma-Dotierung mit Barrierestoff ausgesetzt wird. Bei diesem Vorgang werden die Lochwände des Kontaktlochs dotiert (z.B. nitridisiert). Der Vorteil dieser Maßnahme besteht darin, daß nun auch durch die Lochwände des Kontaktloches kein Wasserstoff durchtreten und zu dem Kondensatormaterial hindiffundieren kann. Dies ist wichtig, weil gerade bei dem nachfolgenden Befüllen des Kontaktlochs, beispielsweise mit Wolfram (W), relativ große Mengen von Wasserstoff freigesetzt werden.

Die Plasma-Dotierung kann zweckmäßigerweise entweder durch ein PIII-(Plasmaimmersions-Ionenimplantations-)Verfahren oder durch ein PLAD-(sog. Plasmadotier-)Verfahren herbeigeführt werden. Beide genannten Verfahren ermöglichen die gezielte Einstellung einer isotropen ("Plasmawolke") und einer anisotropen ("ballistische Implantation") Dotierkomponente in Abhängigkeit von den gewählten Verfahrensparametern. Durch die Erhöhung der isotropen Dotierkomponente lassen sich beispielsweise auch unregelmäßige Oberflächentopologien (z.B. Gräben, Löcher usw.) gleichmäßig dotieren.

Weitere vorteilhafte Maßnahmen sind in den Unteransprüchen angegeben.

Die Erfindung wird im folgenden anhand von Ausführungsbeispielen unter Bezugnahme auf die Zeichnung näher erläutert; in dieser zeigt:
- Fig. 1: eine Querschnittsansicht zur Erläuterung von zwei im Stand der Technik bekannten, für die Anwendung des erfindungsgemäßen Verfahrens geeigneten Aufbaukonzepten einer Speicherzelle; und
- Fig. 2A bis E: Querschittsansichten eines erfindungsgemäß hergestellten Halbleiterbauelements nach einem der in Fig. 1 gezeigten Aufbaukonzepte in unterschiedlichen Stadien des erfindungsgemäßen Verfahrens.

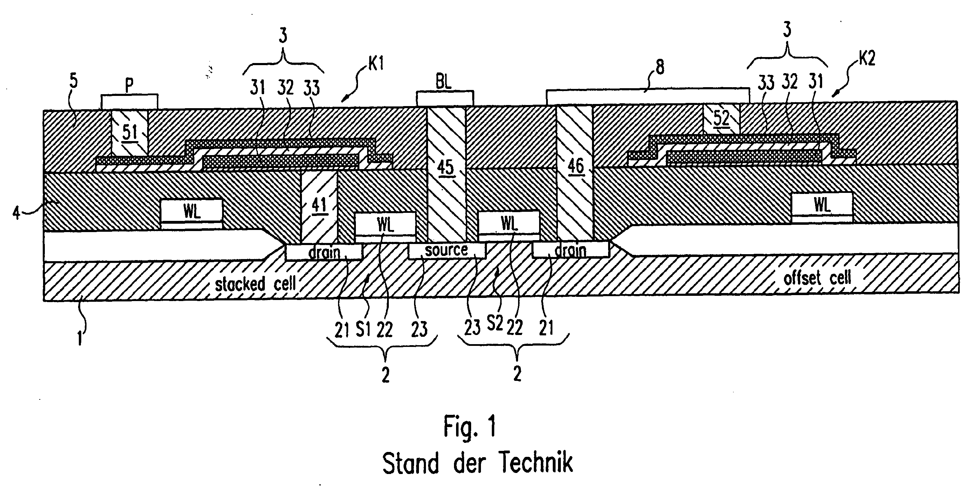

Anhand Fig. 1 werden zwei an sich bekannte Aufbaukonzepte für Speicherzellen erläutert, bei denen jeweils das erfindungsgemäße Verfahren zur Anwendung gebracht werden kann. Den beiden Aufbaukonzepten ist gemeinsam, daß ein Schalttransistor S1, S2 in einer unteren Ebene unmittelbar auf einem Halbleitersubstrat 1 geformt ist und ein Speicherkondensator K1, K2 in einer oberen Ebene angeordnet ist, wobei die beiden Ebenen durch eine dazwischenliegende Isolationsschicht 4 voneinander getrennt sind.

Gemäß dem ersten Aufbaukonzept ("stacked cell") sind der Schalttransistor S1 und der Speicherkondensator K1 im wesentlichen direkt übereinander angeordnet, wobei die untere Elektrode 31 des Speicherkondensators S1 über ein mit einem leitfähigen Material gefülltes Kontaktloch 41 ("plug") mit einem Drain-Gebiet 21 des MOS-Transistors S1, 2 durch die Isolationsschicht 4 hindurch elektrisch verbunden ist.

Gemäß dem zweiten Aufbaukonzept ("offset cell") sind der Schalttransistor S2 und der Speicherkondensator K2 voneinander versetzt angeordnet, wobei die obere Elektrode 33 des Speicherkondensators K2 durch zwei Kontaktlöcher mit dem Drain-Gebiet 21 des MOS-Transistors S2, 2 elektrisch verbunden ist.

In Fig. 1 sind beide Aufbaukonzepte lediglich aus Gründen der vereinfachten Darstellung in einem einzigen Bauelement vereint dargestellt.

Im folgenden wird die Bauelementstruktur und deren Herstellungsweise anhand der "stacked cell" näher erläutert. Die Beschreibung ist aber größtenteils auf die "offset cell" übertragbar. Vergleichbare Bauelemente der "offset cell" sind daher mit denselben Bezugszeichen gekennzeichnet.

Auf einem Halbleitersubstrat 1 wird zunächst der bereits erwähnte MOS-Transistor 2 hergestellt, indem durch eine n- oder p-Dotierung das Drain-Gebiet 21 und ein Source-Gebiet 23 gebildet werden, zwischen denen ein Kanal besteht, welcher durch ein über dem Kanal angeordnetes Gate 22 in seiner Leitfähigkeit gesteuert werden kann. Das Gate 22 kann durch eine Wortleitung WL des Speicherbauelements gebildet oder mit dieser verbunden sein. Das Source-Gebiet 23 ist mit einer Bit-Leitung BL des Speicherbauelements verbunden.

Der MOS-Transistor 2 wird anschließend mit der planarisierenden Isolationsschicht, beispielsweise einer ersten Oxidschicht 4, bedeckt.

Auf der ersten Oxidschicht 4 wird ein Speicherkondensator 3 geformt. Zu diesem Zweck wird in die erste Oxidschicht 4 zunächst das Kontaktloch 41 geätzt und mit einem leitfähigen Material, beispielsweise polykristallinem Silizium, gefüllt. Über dem gefüllten Kontaktloch 41 (eventuell durch eine nicht dargestellte Barriereschicht vom "plug" getrennt) wird sodann die untere Elektrode 31 aufgebracht.

Auf die untere Elektrode 31 wird eine dielektrische Schicht 32 eines ferroelektrischen oder paraelektrischen Materials, beispielsweise durch MOCVD oder durch ein Sputter-Verfahren, abgeschieden. Die dielektrische Schicht 32 bildet das Kondensatordielektrikum. Oberhalb der dielektrischen Schicht 32 wird eine obere Elektrode 33 ganzflächig abgeschieden. Die erhaltene Struktur wird schließlich mit einer weiteren planarisierenden Isolationsschicht 5, beispielsweise ebenfalls bestehend aus SiO₂, bedeckt.

In der oberen Isolationsschicht 5 wird ein weiteres Kontaktloch 51 geformt, durch das die obere Elektrode 33 des Speicherkondensators 3 mittels eines geeigneten leitfähigen Materials mit einem äußeren elektrischen Anschluß P (gemeinsame Kondensatorplatte) verbunden werden kann.

Schließlich wird das Source-Gebiet 23 des MOS-Transistors 2 mit der Bit-Leitung BL verbunden, indem ein sich durch beide Isolationsschichten 4 und 5 erstreckendes Kontaktloch 45 gebildet und mit einem leitfähigen Material gefüllt wird.

Bei der im rechten Teil der Fig. 1 dargestellten "offset cell"-Struktur wird ein mit dem Kontaktloch 45 vergleichbares Kontaktloch 46 gebildet, um das Drain-Gebiet 21 des MOS-Transistors S2 mittels einer leitenden Querverbindung 8 und eines weiteren, sich durch die obere Isolationsschicht 5 erstreckenden Kontaktlochs 52 mit der oberen Elektrode 33 des Speicherkondensators S2, 2 zu verbinden.

Bei beiden Aufbaukonzepten ist es somit erforderlich, eine Mehrzahl von Kontaktlöchern 41, 51, 45, 46, 52 mit einem elektrisch leitfähigen Kontaktlochmaterial zu füllen. Insbesondere bei kleineren Strukturgrößen eignet sich in einem CVD-Prozeß abgeschiedenes Wolfram (W) gut als Kontaktlochmaterial. Dabei tritt jedoch das Problem auf, daß die W-Abscheidung in dem CVD-(chemical vapor deposition-)Prozeß in einer Wasserstoff-haltigen Atmosphäre abläuft, der Wasserstoff die Pt-Elektroden 31, 33 durchdringen kann und es aufgrund der katalytischen Eigenschaften des Platins zu einer Schädigung des Kondensatormaterials 32 kommen kann.

Wird z.B. SBT als ferroelektrisches Kondensatormaterial eingesetzt, kommt es durch die Reduktion von BiOₓ zur Schädigung dieses Materials. Für andere metalloxidhaltigen Kondensatormaterialien existieren analoge Schädigungsmechanismen, die ebenfalls auf das Eindringen von Wasserstoff und die katalytische Wirkung von Pt (oder anderer inerter Elektrodenmaterialien) zurückzuführen sind.

Im folgenden wird anhand der Fig. 2A bis 2E am Beispiel der "offset cell" erläutert, wie durch das erfindungsgemäße Verfahren der Plasma-gestützten Dotierung einer oder mehrerer Oxidschichten das Eindringen von Wasserstoff in das Kondensatormaterial 32 unterbunden werden kann. Zur einfacheren Erläuterung wird von Stickstoff als Barrierestoff ausgegangen und es werden Verfahrensschritte, die bereits im Zusammenhang mit dem in Fig. 1 dargestellten Stand der Technik erläutert wurden, teilweise weggelassen.

Nach Fertigstellung des Schalttransistors S2 (dargestellt sind in den Fig. 2A bis 2E die Wortleitung WL und das Drain-Gebiet 21 desselben) wird gemäß Fig. 2A zunächst die bereits anhand Fig. 1 erläuterte Abscheidung der ersten Oxidschicht 4 mittels üblicher Techniken vorgenommen. Zur Ausbildung einer ebenen Oberfläche wird die Oxidschicht 4 nachfolgend durch CMP (chemisch-mechanisches Polieren) planarisiert.

In einem nachfolgenden Schritt wird die Oxidschicht 4 mit einer Lackmaskenschicht überzogen, welche sodann z.B. auf photolithographischem Wege strukturiert wird. Dabei wird dafür gesorgt, daß an derjenigen Stelle, an welcher später das Kontaktloch 46 gebildet werden soll, eine Maskenstruktur 6 stehenbleibt.

Daraufhin wird der erfindungsgemäße Niedertemperatur-Nitridisierungsschritt durchgeführt. Der Nitridisierungsschritt erfolgt bei einer Substrattemperatur von 50 bis maximal 120°C und ist daher kompatibel mit der eingesetzten Photomaskentechnik. Die Plasma-Nitridisierung bewirkt, daß außerhalb der Maskenstruktur 6 in einem oberflächennahen Bereich Stickstoff-Atome in die erste Oxidschicht 4 eingebaut werden. Der so geschaffene nitridisierte Oberflächenbereich der ersten Oxidschicht 4 ist mit dem Bezugszeichen 7A bezeichnet.

Während beim "stacked cell"-Konzept nun zunächst das Kontaktloch 41 gebildet, aufgefüllt, mit einer Barriereschicht versehen und darüber dann der Speicherkondensator K1 realisiert wird, wird in dem hier dargestellten Ausführungsbeispiel des "offset cell"-Konzepts nun sogleich der Speicherkondensator K2 aufgebaut. Zu diesem Zweck wird zunächst die untere Pt-Elektrode 31 auf dem nitridisierten Oberflächenbereich 7A der ersten Oxidschicht 4 aufgebracht. Sodann wird die dielektrische, insbesondere para- oder ferroelektrische Schicht 32, bestehend beispielsweise aus BST oder anderen geeigneten Material wie z.B. SBTN, PZT, BTO usw., abgeschieden.

Auf die dielektrische Schicht 32 wird anschließend die obere Pt-Elektrode 33 abgeschieden und zusammen mit der dielektrischen Schicht 32 durch Photolithographie und Ätztechnik strukturiert. Die Abscheidung und Strukturierung der dielektrischen Schicht 32 und der oberen Pt-Elektrode 33 erfolgt vorzugsweise derart, daß beide Schichten sich zumindest auf einer Seite der unteren Elektrode 31 in lateraler Richtung über diese hinaus erstrecken und in Form einer Stufe an der unteren Elektrode 31 anliegen. Durch den Stufenbereich wird die wirksame Kondensatorfläche vergrößert.

Diese Struktur wird sodann mit einer dünnen zweiten Oxidschicht bestehend z.B. aus SiO₂ überzogen.

Im folgenden werden auf der zweiten Oxidschicht an geeigneten Stellen auf lithographischem Wege Photolack-Maskenstrukturen 9.1 und 9.2 erzeugt. Die Maskenstruktur 9.2 wird vorzugsweise mittig über dem Speicherkondensator K2 angebracht. Die Maskenstruktur 9.1 überdeckt einen Bereich der zweiten Oxidschicht, welcher unmittelbar über dem nicht-nitridisierten Bereich der ersten nitridisierten Oxidschicht 7A liegt.

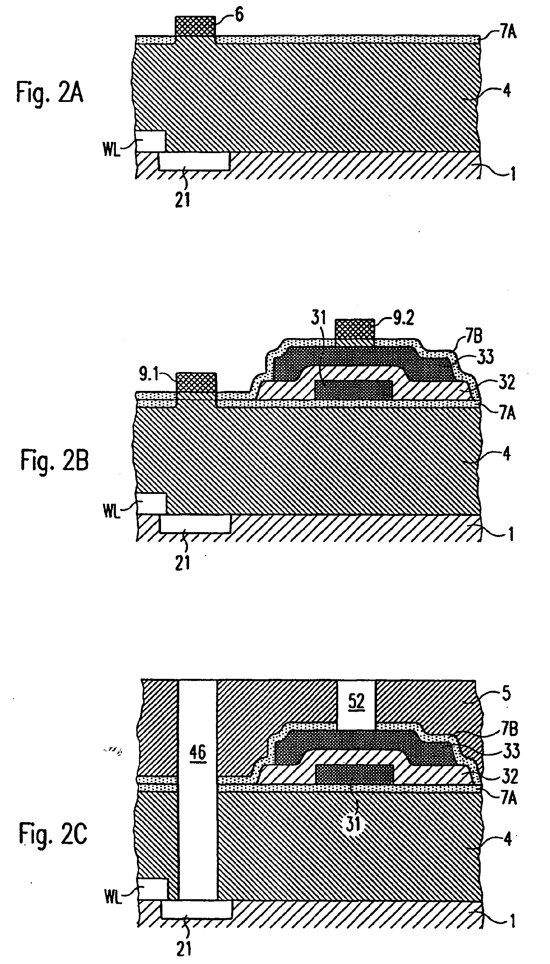

Die dünne zweite Oxidschicht wird anschließend ebenfalls einer Plasma-Nitridisierung unterzogen. Je nach Schichtdicke der zweiten Oxidschicht und den bei der Nitridisierung verwendeten Verfahrensparametern wird diese in ihrer gesamten Dicke oder lediglich in einem oberflächennahen Bereich nitridisiert. Dabei wird die in Fig. 2B gezeigte nitridisierte zweite Oxidschicht 7B gebildet, welche unterhalb der Photolack-Maskenstrukturen 9.1 und 9.2 weiterhin aus nicht-nitridisiertem Oxidmaterial besteht.

Über der beschriebenen Struktur wird sodann die planarisierende obere Isolationsschicht 5, vorzugsweise ebenfalls eine SiO₂-Schicht, abgelagert. Bei diesem Prozeß, der unter Beteiligung von Wasserstoff erfolgen kann, ist der Kondensator 3 bereits durch die zweite nitridisierte Oxidschicht 7B geschützt.

Danach werden die beiden Kontaktlöcher 46 und 52 geätzt. Aufgrund der durch die Maskierungen 6, 9.1 und 9.2 erzeugten Strukturierungen der nitridisierten Oxidschichten 7A und 7B können beide Kontaktlöcher 46 und 52 durch eine übliche Oxid-Ätzung gebildet werden. Eine Ätzung unterschiedlicher Schichtmaterialien ist nicht erforderlich. Folglich weisen die Kontaktlöcher 46 und 52 ausgesprochen maßhaltige und ebene Innenwandflächen auf, wodurch eine laterale Strukturverkleinerung begünstigt wird. Die Kontaktlöcher 46, 52 können gemeinsam in einem einzelnen Ätzschritt oder auch in zwei einzelnen Ätzschritten gebildet werden.

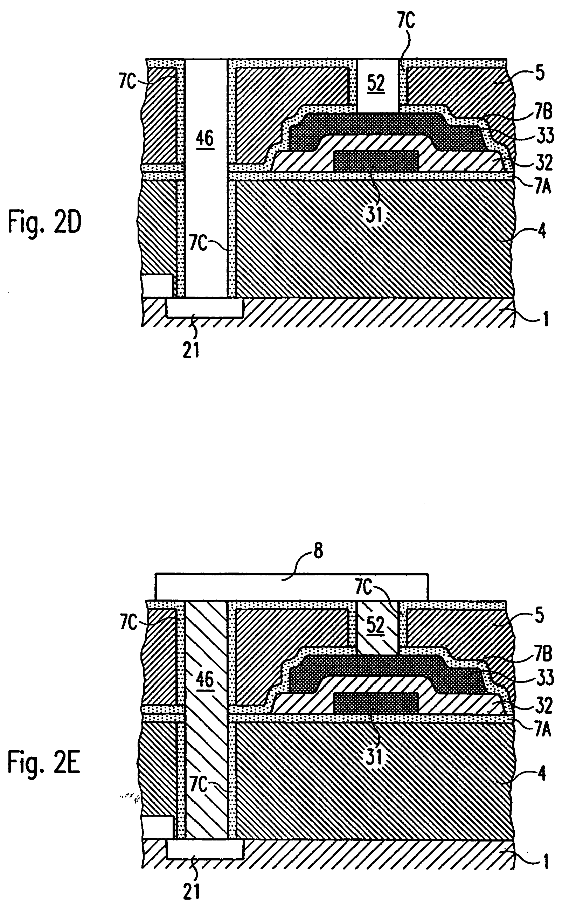

Gemäß Fig. 2D kann nun ein dritter Plasma-Nitridisierungsschritt durchgeführt werden. Dabei werden oberflächennahe Innenwandflächenbereiche 7C der beiden Kontaktlöcher 46 und 52 sowie ein Oberflächbereich der oberen Oxidschicht 5 nitridisiert.

Die Kontaktlöcher 46 und 52 werden sodann in der bereits beschriebenen Weise mit einem geeigneten leitfähigen Material, beispielsweise W, gefüllt. Danach kann ein nicht dargestellter Weise ein CMP-Schritt zur Schaffung einer planaren Oberfläche durchgeführt werden.

Zuletzt wird durch Erzeugung der leitfähigen Querverbindung 8 über den beiden Kontaktlöchern 46 und 52 eine elektrische Verbindung zwischen dem Source-Gebiet 21 und der oberen Kondensatorelektrode 33 hergestellt, siehe Fig. 2E.

Im folgenden werden zwei Möglichkeiten zum Nitridisieren der verschiedenen Oxidschichten im Stickstoff-Plasma beschrieben. Beide Verfahren sind im Zusammenhang mit der n- bzw. p-Dotierung von Silizium mit geeigneten Dotierstoffen bekannt.

Das PIII-Verfahren wird üblicherweise in einer aus zwei Kammern bestehenden Anlage durchgeführt. In der einen Kammer wird ein ständig brennendes Stickstoff-Plasma einer hohen Plasmadichte erzeugt. Zur Kontrolle der Plasmadichte kann ein magnetisches Feld eingesetzt werden.

Das Substrat mit den zu nitridisierenden Oxidschichten befindet sich in der anderen Kammer. Die beiden Kammern sind durch eine Lochblende miteinander verbunden. Es wird nun für kurze Zeit eine Spannung an das Substrat angelegt, wodurch Stickstoff-Ionen aus dem Plasma extrahiert, durch die Lochblende auf das Substrat 1 zu beschleunigt und in der jeweilig freiliegenden Oxidschicht abgebremst werden.

Durch die Einstellung der Plasma- und Extraktionsbedingungen kann der Anisotropiegrad der Nitridierung in starkem Maße beeinflußt werden. Bei einer hohen Extraktionsspannung tritt anisotrope Ionenimplantation auf. Z.B. durch Erniedrigung der Extraktionsspannung, Erhöhung der Plasmadichte sowie durch eine Änderung der geometrischen Verhältnisse kann erreicht werden, daß die Nitridisierung durch eine ausgedehnte "Plasma-Wolke" bewirkt wird. In diesem Fall ist eine gleichmäßige Nitridisierung der Oxidschichten auch bei unregelmäßigen Oberflächentopologien erreichbar und es hat sich gezeigt, daß Kontaktlöcher mit einem Öffnungsverhältnis bis etwa 1:12 problemlos in voller Länge nitridisiert werden können.

Das PLAD-Verfahren wird üblicherweise in einer einzelnen Plasmakammer durchgeführt. Die Anlage ist ähnlich einer Sputter-Anlage aufgebaut. Zwischen zwei Elektroden wird eine Hochfrequenzspannung angelegt und ein Stickstoff-Plasma gezündet. Das Substrat befindet sich auf derjenigen Elektrode, zu welcher die Stickstoff-Ionen hin beschleunigt werden. Das System arbeitet sinngemäß wie eine umgepolte Sputter-Anlage.

Auch bei dem PLAD-Verfahren kann der Anisotropiegrad der Nitridisierung durch die Anlagengeometrie und die Konfiguration des Stickstoff-Plasmas wunschgemäß eingestellt werden.

Mit beiden Verfahren läßt sich eine typische Nitridisierungsdosis im Bereich von 10¹⁹ bis 10²² Atome/cm² einstellen. Typische Nitridisierungsenergien (kinetische Energie der beschleunigten Stickstoff-Ionen beim Auftreffen auf die Oxidschichten) liegen im Bereich von 1 bis 12 keV. Bei beiden Verfahren ist es ferner möglich, eine gewünschte Dicke des nitridisierten Oxidschichtbereichs durch eine Änderung der Nitridisierungsenergie während des Nitridisierungsschrittes sukzessive aufzubauen. Der Nitridisierungsvorgang beginnt dann bei der höchsten Nitridisierungsenergie und endet bei der geringsten Nitridisierungsenergie. Die Dauer des gesamten Nitridisierungsschrittes beträgt bei einer Nitridisierungsdosis von 10²⁰ Atomen/cm² typischerweise etwa 60 Sekunden.

## Patentansprüche

1. Verfahren zur Herstellung eines Halbleiterbauelements, bei welchem
- über einem Substrat (1) eine erste Oxidschicht (4) erzeugt wird; und
- über der ersten Oxidschicht (4) ein Kondensator (3) enthaltend eine untere und eine obere Elektrode (31, 33) und eine dazwischen abgeschiedene metalloxidhaltige Kondensatormaterialschicht (32) gebildet wird;
**dadurch gekennzeichnet,**
- **daß** vor der Bildung des Kondensators (3) die erste Oxidschicht (4) unter Verwendung eines Plasma-Dotierverfahrens mit einem eine Wasserstoff-Diffusionsbarriere in der ersten Oxidschicht aufbauenden Barrierestoff dotiert wird.

2. Verfahren zur Herstellung eines Halbleiterbauelements, bei welchem
- über einem Substrat eine erste Isolationsschicht (4) erzeugt wird; und
- über der ersten Isolationsschicht (4) ein Kondensator enthaltend eine untere und eine obere Elektrode (31, 33) und eine dazwischen abgeschiedene metalloxidhaltige Kondensatormaterialschicht (32) gebildet wird;
**dadurch gekennzeichnet,**
- **daß** über dem Kondensator (3) eine zweite Oxidschicht erzeugt wird; und
- **daß** die zweite Oxidschicht (4) unter Verwendung eines Plasma-Dotierverfahrens mit einem eine Wasserstoff-Diffusionsbarriere in der zweiten Oxidschicht (4) aufbauenden Barrierestoff dotiert wird.

3. Verfahren nach Anspruch 1 und 2,
**dadurch gekennzeichnet,**
- **daß** die erste dotierte Oxidschicht (7A) und die zweite dotierte Oxidschicht (7B) den Kondensator (3) allseits umschließen.

4. Verfahren nach einem der vorhergehenden Ansprüche,
**dadurch gekennzeichnet,**
- **daß** es sich bei dem Barrierestoff um Stickstoff handelt.

5. Verfahren nach einem der vorhergehenden Ansprüche,
**dadurch gekennzeichnet,**
- **daß** vor der Plasma-Dotierung auf der ersten (4) und/oder zweiten Oxidschicht eine Maske (6; 9.1, 9.2) aufgebracht wird, mittels welcher die Dotierung der Oxidschicht strukturiert wird; und
- **daß** nachfolgend ein Oxid-Ätzschritt durchgeführt wird.

6. Verfahren nach Anspruch 5,
**dadurch gekennzeichnet,**
- **daß** nach dem Oxid-Ätzschritt, mittels welchem ein Kontaktloch (45, 46, 51, 52) erzeugt wird, die geschaffene Struktur ein weiteres Mal unter Verwendung des Plasma-Dotierverfahrens mit dem Barrierestoff zur Dotierung der Kontaktlochwände dotiert wird.

7. Verfahren nach einem der vorhergehenden Ansprüche,
**dadurch gekennzeichnet,**
- **daß** die Dotierung mittels eines Plasmainmersions-Ionenimplantationsverfahrens durchgeführt wird.

8. Verfahren nach einem der vorhergehenden Ansprüche,
**dadurch gekennzeichnet,**
- **daß** die Barrierestoff-Dosis bei der Plasma-Dotierung der ersten (4) und/oder der zweiten Oxidschicht im Bereich von 10¹⁹ bis 10²² Atome/cm² liegt.

9. Verfahren nach einem der vorhergehenden Ansprüche,
**dadurch gekennzeichnet,**
- **daß** bei der Plasma-Dotierung eine Barrierestoff-Implantationsenergie im Bereich von 1 bis 12 keV eingesetzt wird.

## Claims

1. Method for fabricating a semiconductor component, in which
- a first oxide layer (4) is produced above a substrate (1); and
- a capacitor (3) containing a bottom and a top electrode (31, 33) and a metal-oxide-containing capacitor material layer (32) deposited in between is formed above the first oxide layer (4);
**characterized**
- **in that**, prior to the formation of the capacitor (3), the first oxide layer (4) is doped with a barrier substance which builds up a hydrogen diffusion barrier in the first oxide layer, using a plasma doping method.

2. Method for fabricating a semiconductor component, in which
- a first insulation layer (4) is produced above a substrate; and
- a capacitor containing a bottom and a top electrode (31, 33) and a metal-oxide-containing capacitor material layer (32) deposited in between is formed above the first insulation layer (4);
**characterized**
- **in that** a second oxide layer is produced above the capacitor (3); and
- **in that** the second oxide layer (4) is doped with a barrier substance which builds up a hydrogen diffusion barrier in the second oxide layer (4), using a plasma doping method.

3. Method according to Claims 1 and 2,
**characterized**
- **in that** the first doped oxide layer (7A) and the second doped oxide layer (7B) enclose the capacitor (3) on all sides.

4. Method according to one of the preceding claims,
**characterized**
- **in that** the barrier substance is nitrogen.

5. Method according to one of the preceding claims,
**characterized**
- **in that**, prior to the plasma doping, a mask (6; 9.1, 9.2) is applied on the first (4) and/or second oxide layer, which mask is used to pattern the doping of the oxide layer; and
- **in that** an oxide etching step is subsequently carried out.

6. Method according to Claim 5,
**characterized**
- **in that**, after the oxide etching step, by means of which a contact hole (45, 46, 51, 52) is produced, the structure created is doped once again, using the plasma doping method, with the barrier substance for the purpose of doping the contact hole walls.

7. Method according to one of the preceding claims,
**characterized**
- **in that** the doping is carried out using a plasma immersion ion implantation method.

8. Method according to one of the preceding claims,
**characterized**
- **in that** the barrier substance dose during the plasma doping of the first (4).and/or of the second oxide layer lies in the range from 10¹⁹ to 10²² atoms/cm².

9. Method according to one of the preceding claims,
**characterized**
- **in that** a barrier substance implantation energy in the range from 1 to 12 keV is used during the plasma doping.

## Revendications

1. Procédé pour fabriquer un composant à semiconducteurs, dans lequel
- on produit sur un substrat (1) une première couche (4) d'oxyde ; et
- on forme sur la première couche (4) d'oxyde un condensateur (3) comportant des électrodes (31, 33) inférieure et supérieure et une couche (32) de matériau de condensateur contenant un oxyde métallique disposé entre elles ;
**caractérisé**
- **en ce que**, avant la formation du condensateur (3), on dope la première couche (4) d'oxyde en utilisant un procédé de dopage au plasma par une matière formant une barrière à la diffusion de l'hydrogène dans la première couche d'oxyde.

2. Procédé pour fabriquer un composant à semiconducteurs, dans lequel
- on produit sur un substrat une première couche (4) d'isolation ; et
- sur la première couche (4) d'isolation on forme un condensateur comportant des électrodes (31, 33) inférieure et supérieure et une couche (32) de matériau de condensateur contenant un oxyde métallique disposé entre elles;
**caractérisé**
- **en ce que**, sur le condensateur (3), on produit une deuxième couche d'oxyde ; et
- **en ce que** l'on dope la deuxième (4) couche d'oxyde en utilisant un procédé de dopage au plasma d'un matériau formant une barrière à la diffusion de l'hydrogène dans la deuxième couche (4) d'oxyde.

3. Procédé suivant la revendication 1 et 2,
**caractérisé**
- **en ce que** la première couche (7A) d'oxyde dopée et la deuxième couche (7B) d'oxyde dopée du condensateur (3) enferment le condensateur (3) de tous les côtés.

4. Procédé suivant l'une des revendications précédentes,
**caractérisé**
- **en ce que** la matière formant barrière est de l'azote.

5. Procédé suivant l'une des revendications précédentes,
**caractérisé**
- **en ce que**, avant le dopage au plasma, on dépose sur la première couche (4) d'oxyde et/ou la deuxième couche d'oxyde un masque (6, 9.1, 9.2), au moyen duquel le dopage de la couche d'oxyde est structuré ; et
- **en ce que**, ensuite, on effectue une attaque d'oxyde.

6. Procédé suivant la revendication 5,
**caractérisé**
- **en ce que**, après l'étape d'attaque d'oxyde, au moyen de laquelle il est produit un trou (45, 46, 51, 52) de contact, la structure ainsi réalisée est dopée une fois supplémentaire en utilisant le procédé de dopage au plasma par le matériau de barrière pour doper les parois du trou de contact.

7. Procédé suivant l'une des revendications précédentes,
**caractérisé**
- **en ce que** le dopage est effectué au moyen d'un procédé de plasma immersion - implantation ionique.

8. Procédé suivant l'une des revendications précédentes,
**caractérisé**
- **en ce que** la dose de matière de barrière pour le dopage au plasma de la première couche (4) d'oxyde et/ou de la deuxième couche d'oxyde est comprise entre 10¹⁹ et 10²² atomes/cm².

9. Procédé suivant l'une des revendications précédentes,
**caractérisé**
- **en ce que**, pour le dopage au plasma, on utilise une énergie d'implantation de matière de barrière comprise entre 1 et 12 keV.
